(19) Europäisches Patentamt
European Patent Office
Office européen des brevets

(11) **EP 2 575 229 A2**

(12) **EUROPEAN PATENT APPLICATION**

(43) Date of publication:
**03.04.2013 Bulletin 2013/14**

(21) Application number: **11187245.3**

(22) Date of filing: **31.10.2011**

(51) Int Cl.:
**H02J 3/00** (2006.01)       **H02J 13/00** (2006.01)
**F24J 2/52** (2006.01)       **H01L 31/0224** (2006.01)
**H02M 7/42** (2006.01)

| | |
|---|---|
| (84) Designated Contracting States: **AL AT BE BG CH CY CZ DE DK EE ES FI FR GB GR HR HU IE IS IT LI LT LU LV MC MK MT NL NO PL PT RO RS SE SI SK SM TR** Designated Extension States: **BA ME** | (72) Inventors: • **Bae, Young Sang** **139-220 Seoul (KR)** • **Oh, Seong Jin** **133-836 Seoul (KR)** • **Kim, Kyoung Hwan** **446-860 Gyeonggi-do (KR)** |
| (30) Priority: **27.09.2011 KR 20110097363** | (74) Representative: **Neobard, William John et al** **Kilburn & Strode** **20 Red Lion Street** **London WC1R 4PJ (GB)** |
| (71) Applicant: **KACO New Energy Inc.** **Seongnam-si, Gyeonggi-do 462-807 (KR)** | |

(54) **Photovoltaic generation system using parallel inverter connected grid**

(57)     A photovoltaic generation system using grid-connected parallel inverters comprises a plurality of photovoltaic generation devices connected in parallel with each other, and a transformer configured to transform and transfer output voltages of the photovoltaic generation devices to a grid, wherein the photovoltaic generation device includes: a photovoltaic module configured to convert photovoltaic energy into DC electrical energy; an inverter configured to convert the DC electrical energy outputted from the photovoltaic module into AC electrical energy; an LC filter configured to remove noise included in the AC electrical energy which is outputted from the inverter; and a Y-connected capacitor group which is connected between one terminal of a reactor in the LC filter and one terminal of the photovoltaic module and is configured to reduce stray current.

Figure 5

**Description**

The present invention relates to a photovoltaic generation system, and more particularly, to a photovoltaic generation system using grid-connected parallel inverters.

It has been determined that fossil energy, such as oil, coal, and natural gas, is available for 30 years in case of oil, 80 years in case of coal, and 180 in case of natural gas. Due to the United Nations Framework Convention on Climate Change (UNFCCC), such as the Kyoto protocol, and so on, new & renewable energy has received an increasing amount of attention. The new energy field includes a fuel cell, coal liquefaction/gasification, and hydrogen energy, and the renewable field includes solar heat, photovoltaic generation, biomass, wind power, small hydro power, geothermy, ocean energy, and waste energy.

Among the new & renewable energy, the photovoltaic generation, which is being the most actively studied, and is permanent enough to be used for five billion, differently from oil, coal, and natural gas, which may be exhausted within the next decades to centuries. In addition, since the photovoltaic generation uses clean energy, it is possible to solve environmental pollution problems which may occur in using fossil energy, and to supply required places with energy required therein, differently from water power or atomic power generation. In addition, since most of a photovoltaic generation system is constituted with electronic elements, the photovoltaic generation system is long in lifetime, is easy in maintenance and repair, and has no mechanical noise.

Recently, the market for large-scale photovoltaic generation plants of several megawatts to several tens of megawatts or more has been rapidly grown. Accordingly, with respect to an inverter which is a power transformation device for grid-connected photovoltaic generation in the large-scale photovoltaic generation plants, a technology for producing a more efficient large-scale inverter with a lower unit price has been required. Now, most of photovoltaic generation systems use a parallel operating technology, in which a multi-wiring medium voltage (MV) transformer is used, a plurality of large-scale grid-connected photovoltaic inverters having individual capacities are connected in parallel with each other to increase the generation capacity.

The reason why it is required to use a transformer having a structure of multi-wiring is that a stray capacitance exists between a photovoltaic module and the ground due to the structural characteristic of the photovoltaic module. When a Voltage of a harmonic component occurs at the stray capacitance, leakage current occurs through the ground, and several problems are accompanied.

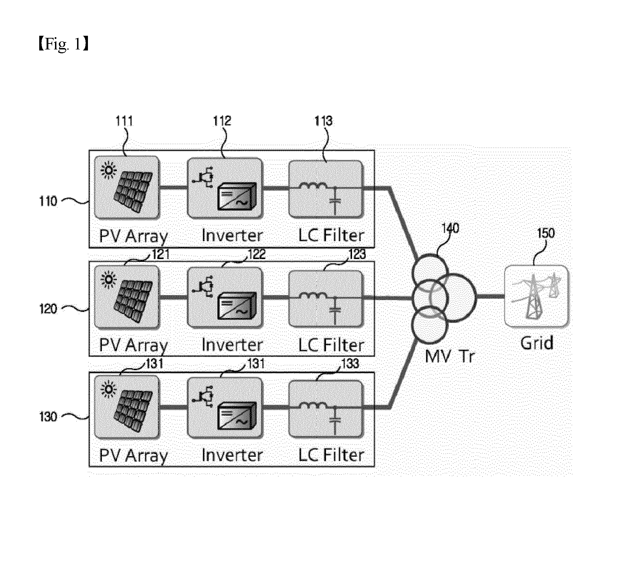

Therefore, as shown in FIG. 1, the conventional parallel photovoltaic inverters are using multi-wiring MV transformers for electrical separation between inverters and isolation of a grid from inverters although a high unit price, a difficulty in design, and inefficiency are recognized.

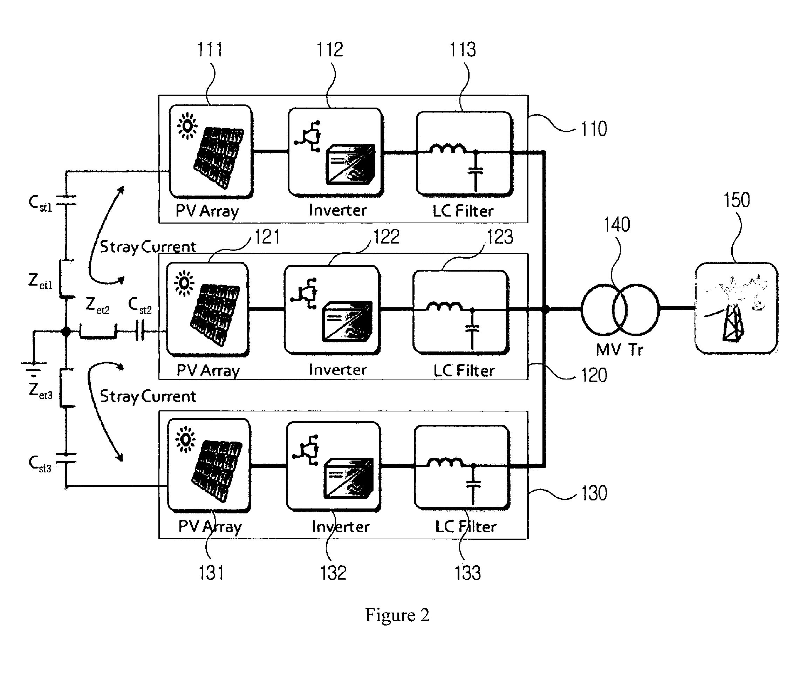

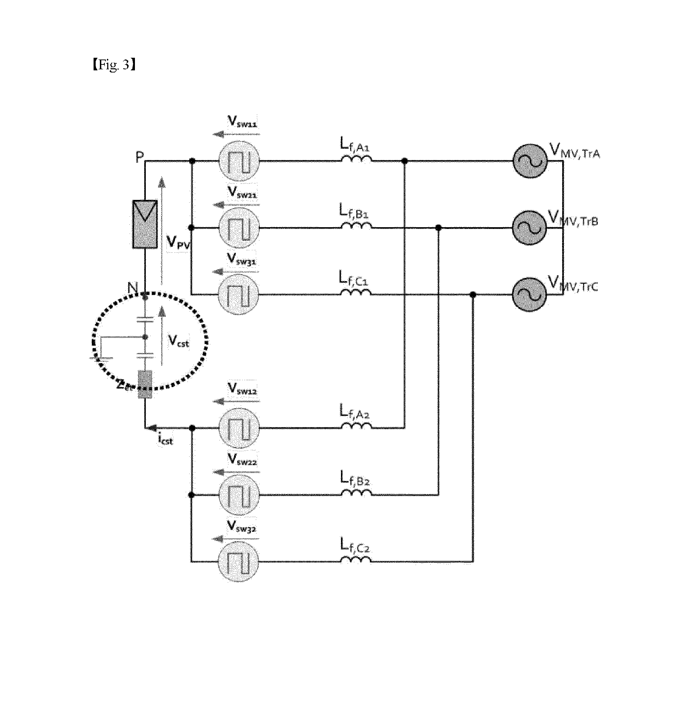

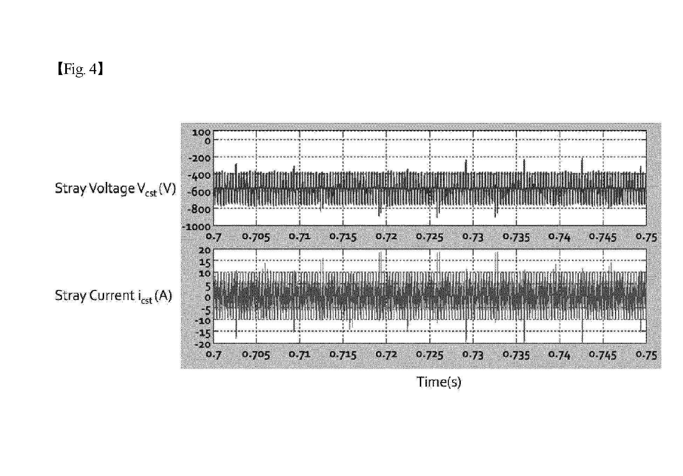

FIG. 2 is a circuit diagram illustrating the configuration of a conventional photovoltaic generation system using a double wiring transformer, FIG. 3 is an equivalent circuit of FIG. 2, and FIG. 4 is a waveform view obtained through a simulation of a stray voltage and stray current in a conventional grid-connected parallel inverter.

Referring to FIG. 2, the conventional photovoltaic generation system using a double wiring transformer includes: a plurality of photovoltaic generation devices 110, 120, and 130; and a double wiring transformer 140 for transforming the output voltages of the photovoltaic generation devices 110, 120, and 130, wherein a grid 150 is connected with the output of the transformer 140.

The photovoltaic generation devices 110, 120, and 130 include: photovoltaic modules 111, 121, and 131 for converting photovoltaic energy into DC electrical energy; inverters 112, 122, and 132 for converting the DC electrical energy into AC electrical energy; and LC filters 113, 123, and 133 for removing noise included in the AC electrical energy, respectively.

Meanwhile, an undesired stray capacitance Cst1 exists between the first photovoltaic module 111 and the ground G, and an undesired stray capacitance Cst2 exists between the second photovoltaic module 121 and the ground G. That is to say, a grounding impedance Zet1 and the undesired stray capacitance Cst1 exist between the first photovoltaic module 111 and the ground G, and a grounding impedance Zet2 and the undesired stray capacitance Cst2 exist between the second photovoltaic module 121 and the ground G, so that the first photovoltaic module 111 and second photovoltaic module 121 is at a connected state in a circuit.

Accordingly, when the plurality of photovoltaic generation devices operate in parallel, for example, a closed loop connected in order of "the first photovoltaic module 111, the first inverter 112, the first LC filter 113, the second LC filter 123, the second inverter 122, the second photovoltaic module 121, the second stray capacitor Cst2, and the first stray capacitor Cst1," and stray current flows along the closed loop.

Referring to FIG. 2, a stray voltage is calculated as follows:

$$V_{cst} = -V_{sw12} - Lf_{A2}\frac{di}{dt} + Lf_{A1}\frac{di}{dt} + V_{sw11} - V_{pv} \quad \text{................} \quad (1)$$

$$V_{cst} = -V_{sw22} - Lf_{B2}\frac{di}{dt} + Lf_{B1}\frac{di}{dt} + V_{sw21} - V_{pv} \quad \text{................} \quad (2)$$

$$V_{cst} = -V_{sw32} - Lf_{C2}\frac{di}{dt} + Lf_{C1}\frac{di}{dt} + V_{sw31} - V_{pv} \quad \text{................} \quad (3)$$

In a three-phase balanced state, when Equations 1 to 3 are added to produce one equation, and then both sides of the produced equation are divided by three, the stray voltage Vcst can be obtained as Equation 4.

$$V_{cst} = \frac{-V_{sw12} - V_{sw22} - V_{sw32} + V_{sw11} + V_{sw21} + V_{sw31}}{3} - V_{pv} \quad \text{...} \quad (4)$$

That is to say, the stray capacitance appears in the form of a switching voltage between inverters, and the switching voltage between the inverters each of which is independently controlled cannot be same. Therefore, it can be understood that the stray capacitance appears in the form of a switching frequency, and very large stray current flows as expressed in the following equation.

$$i_{cst} = 2\pi \times f_{sw} \times C_{st} \times V_{cst}$$

As described above, the conventional photovoltaic generation system using a double wiring transformer causes undesired stray current, so that there is a danger of an electrical shock when the worker touches a photovoltaic module, the photovoltaic module is easily deteriorated and is easily broken due to the deterioration thereof, and high harmonic distortion appears in the output waveform of the inverter.

Accordingly, the present invention has been made in an effort to address problems occurring in the related art.

Embodiments provide a photovoltaic generation system using grid-connected parallel inverters which can significantly reduce stray current.

Embodiments provide a photovoltaic generation system using grid-connected parallel inverters which can reduce deterioration of a photovoltaic module due to stray current.

Embodiments provide a photovoltaic generation system using grid-connected parallel inverters which can reduce harmonic distortion in an output waveform.

Embodiments provide a photovoltaic generation system using grid-connected parallel inverters which significantly reduces stray current using a Y-connected capacitor group and thus can use a double wiring transformer instead of a multi-wiring transformer.

In one aspect of the disclosure, there is provided a photovoltaic generation system using grid-connected parallel inverters, the photovoltaic generation system comprising: a plurality of photovoltaic generation devices connected in parallel with each other; and a transformer configured to transform and transfer output voltages of the photovoltaic generation devices to a grid, wherein the photovoltaic generation device comprises: a photovoltaic module configured to convert photovoltaic energy into DC electrical energy; an inverter configured to convert the DC electrical energy outputted from the photovoltaic module into AC electrical energy; an LC filter configured to remove noise included in the AC electrical energy which is outputted from the inverter; and a Y-connected capacitor group which is connected between one terminal of a reactor in the LC filter and one terminal of the photovoltaic module and is configured to reduce stray current.

In an embodiment, the LC filter further comprises a delta-connected capacitor group configured to filter noise at an output terminal of the inverter.

In an embodiment, a stray impedance value by a stray capacitance component between the photovoltaic module and a ground is larger than an impedance value by the Y-connected capacitor group.

In an embodiment, a frequency forming an impedance by the Y-connected capacitor group is a switching frequency of the inverter.

In an embodiment, stray current flowing between the photovoltaic module and a ground is dependent on a capacitance value of the Y-connected capacitor group and a switching frequency of the inverter.

In an embodiment, a resonance frequency by the LC filter and the Y-connected capacitor group is different from a switching frequency of the inverter.

In an embodiment, the transformer is any one of a double wiring transformer and a multi-wiring transformer.

In another aspect of the present disclosure, there is provided a photovoltaic generation system using grid-connected parallel inverters, the photovoltaic generation system comprising: a photovoltaic module configured to convert photovoltaic energy into DC electrical energy; an inverter configured to convert the DC electrical energy outputted from the photovoltaic module into AC electrical energy; an LC filter configured to remove noise included in the AC electrical energy which is outputted from the inverter; a Y-connected capacitor group which is connected between one terminal of a reactor in the LC filter and one terminal of the photovoltaic module and is configured to reduce stray current; and an isolation transformer configured to block the output of a DC portion outputted from the LC filter.

In an embodiment, stray current flowing between the photovoltaic module and a ground is determined depending on a capacitance value of the Y-connected capacitor group and a switching frequency of the inverter.

In the drawings:

FIG. 1 is a circuit diagram illustrating the configuration of a conventional photovoltaic generation system using a multi-wiring transformer;

FIG. 2 is a circuit diagram illustrating the configuration of a conventional photovoltaic generation system using a double wiring transformer;

FIG. 3 is an equivalent circuit of FIG. 2;

FIG. 4 is a waveform view obtained through a simulation of a stray voltage and stray current in a conventional grid-connected parallel inverter;

FIG. 5 is a circuit diagram of a photovoltaic generation system using grid-connected parallel inverters;

FIG. 6 is an equivalent circuit of FIG. 5; and

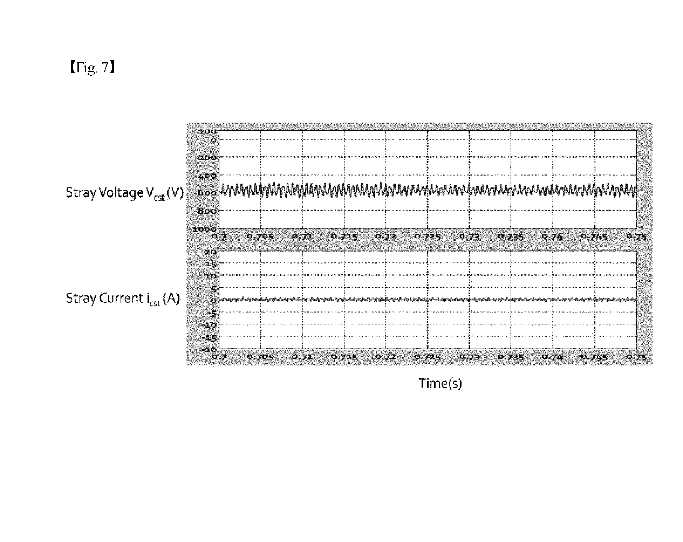

FIG. 7 is a waveform diagram showing a result obtained by simulation of stray voltage and stray current of grid-connected parallel inverters.

Wherever possible in this description, the same reference numerals will be used throughout the drawings and the description to refer to the same or like parts.

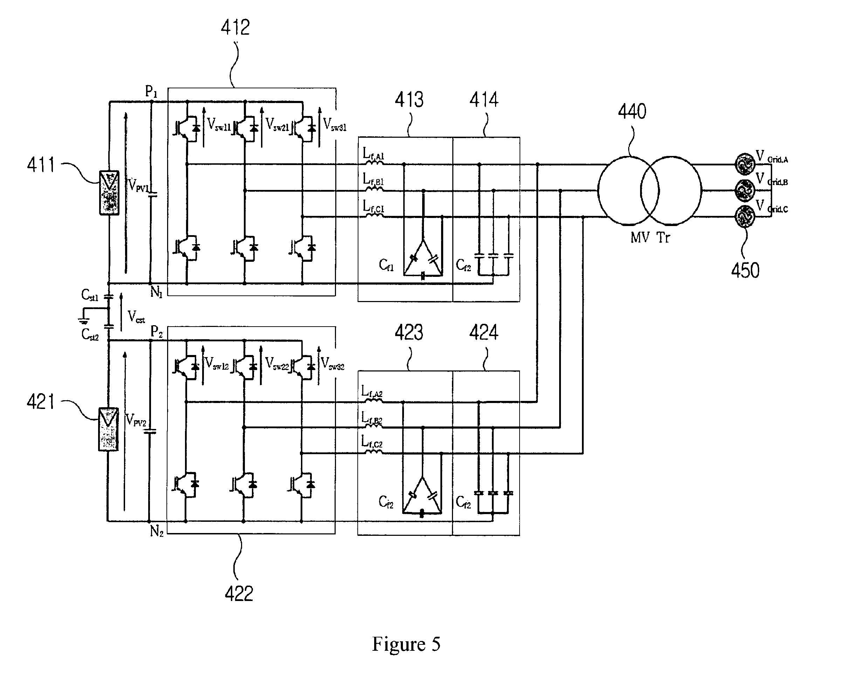

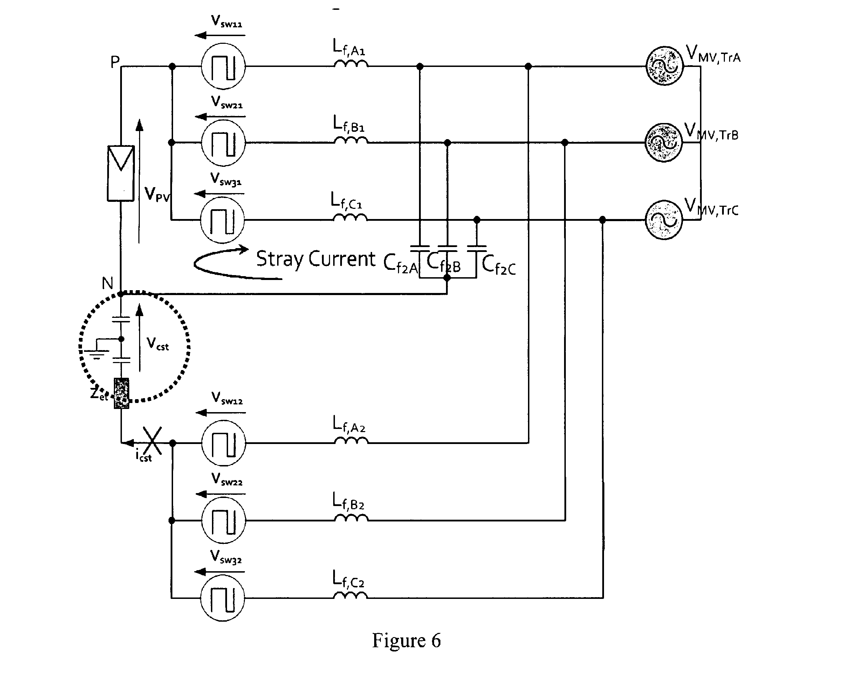

Referring to figures 5 and 6, a photovoltaic generation system using grid-connected parallel inverters includes a plurality of photovoltaic generation devices 410 and 420 connected in parallel with each other, a transformer 440 for transforming the output voltages of the photovoltaic generation devices 410 and 420, and a grid 450 connected with the output of the transformer 440. A double wiring transformer or any of multi-wiring transformers may be used as the transformer 440.

According to an embodiment, the photovoltaic generation devices 410 and 420 include: photovoltaic modules 411 and 421 for converting photovoltaic energy into DC electrical energy; inverters 412 and 422 for converting the DC electrical energy outputted from the photovoltaic modules 411 and 421 into AC electrical energy; LC filters 413 and 423 for removing noise included in the AC electrical energy which are outputted from the inverters 412 and 422; and Y-connected capacitor groups 414 and 424 which are connected between one terminals of reactors in the LC filters 413 and 423 and one terminals of the photovoltaic modules 411 and 421 and reduce stray current, respectively.

In an embodiment, each of the LC filters 413 and 423 includes a delta-connected capacitor group.

With FIG. 5, the voltage component Vcst applied to a stray capacitor is calculated as follows:

$$V_{cst} = -V_{sw12} - Lf_{A2}\frac{di}{dt} - V_{cf2A} \quad ..................... (5)$$

$$V_{cst} = -V_{sw22} - Lf_{B2}\frac{di}{dt} - V_{cf2B} \quad ..................... (6)$$

$$V_{cst} = -V_{sw32} - Lf_{C2}\frac{di}{dt} - V_{cf2C} \quad ..................... (7)$$

When Equations 5 to 7 are added to produce one equation, and then both sides of the produced equation are divided by three, a result thereof may be expressed as follows:

$$V_{cst} = \frac{-V_{sw12} - V_{sw22} - V_{sw32} - V_{Cf2A} - V_{Cf2B} - V_{Cf2C}}{3} \quad ....... (8)$$

When three phases are in parallel, a relation thereof may be expressed as follows:

$$-V_{Cf2A} - V_{Cf2B} - V_{Cf2C} = V_{sw11} + V_{sw21} + V_{sw31} - 3V_{pv}$$

Therefore, in this case, Equation 8 is expressed as Equation 9.

$$V_{cst} = \frac{-V_{sw12} - V_{sw22} - V_{sw32} + V_{sw11} + V_{sw21} + V_{sw31}}{3} - V_{pv} \quad ...... (9)$$

However, since each of the switching voltages passes through a closed circuit of a corresponding LC filter, the voltage component Vcst may be regarded as a sine-wave form of each phase in which a switching frequency is reduced. Therefore, since a three-phase voltage is zero in parallel, the voltage applied to the stray capacitor has a value near to zero. In this case, the resonance frequency fr is expressed as Equation 10, wherein a reactance is a reactor value of an LC filter, and a capacitance is a value of a Y-connected capacitor group.

$$f_r = \frac{1}{2\pi\sqrt{LC}} \quad \dots\dots\dots\dots\dots\dots\dots\dots\dots\dots\dots\dots\dots\dots\dots\dots\dots\dots\dots \quad (10)$$

In addition, when a stray impedance $Z_{cst} = \dfrac{1}{2\pi f \cdot C_{cst}}$ by a stray capacitance component is significantly greater than the impedance $Z_{Cf2} = \dfrac{1}{2\pi f \cdot C_{f2}}$ of the Y-connected capacitor group, stray current $i_{cst}$

do not almost flow. Here, "f" represents the switching frequency of the inverter.

That is to say, when an impedance value using the switching frequency "f" and the capacitance of the Y-connected capacitor group is appropriately selected so that the stray impedance value can be large enough to ignore the impedance value of the Y-connected capacitor group, it is possible to control the stray current to hardly flow.

Compared with FIG. 3, it can be understood that, under the same condition, while stray current of +10 to -10 amperes flows in the conventional system, stray current hardly flows in the system of FIG. 6.

As is apparent from the above description, the present disclosure provides a photovoltaic generation system which can significantly reduce stray current, reduce the deterioration of the photovoltaic module by stray current, and reduce harmonic distortion in an output waveform. In addition, since a Y-connected capacitor group is adopted to significantly reduce stray current, it is possible to use a double wiring transformer in an advantageous position for price, volume, weight, design, etc., as compared with multi-wiring transformers.

Although an embodiment has been described for illustrative purposes, those skilled in the art will appreciate that various modifications, additions and substitutions are possible, without departing from the scope of the invention as defined in the accompanying claims.

**Claims**

1. A photovoltaic generation system using grid-connected parallel inverters, the photovoltaic generation system comprising: a plurality of photovoltaic generation devices connected in parallel with each other; and a transformer configured to transform and transfer output voltages of the photovoltaic generation devices to a grid,
   wherein the photovoltaic generation device comprises:

   a photovoltaic module configured to convert photovoltaic energy into DC electrical energy;
   an inverter configured to convert the DC electrical energy outputted from the photovoltaic module into AC electrical energy;
   an LC filter configured to remove noise included in the AC electrical energy which is outputted from the inverter; and
   a Y-connected capacitor group which is connected between one terminal of a reactor in the LC filter and one terminal of the photovoltaic module and is configured to reduce stray current.

2. The photovoltaic generation system according to claim 1, wherein the LC filter further comprises a delta-connected capacitor group configured to filter noise at an output terminal of the inverter.

3. The photovoltaic generation system according to claim 1 or 2, wherein a stray impedance value by a stray capacitance component between the photovoltaic module and a ground is larger than an impedance value by the Y-connected capacitor group.

4. The photovoltaic generation system according to claim 3, wherein the frequency forming an impedance by the Y-connected capacitor group is a switching frequency of the inverter.

**5.** The photovoltaic generation system according to any preceding claim, wherein stray current flowing between the photovoltaic module and a ground is dependent on a capacitance value of the Y-connected capacitor group and a switching frequency of the inverter.

**6.** The photovoltaic generation system according to any preceding claim, wherein the resonance frequency by the LC filter and the Y-connected capacitor group is different from a switching frequency of the inverter.

**7.** The photovoltaic generation system according to any preceding claim, wherein the transformer is any one of a double wiring transformer and a multi-wiring transformer.

**8.** The photovoltaic generation system according to any preceding claim, wherein the transformer is an isolation transformer configured to block the output of a DC portion outputted from the LC filter

**9.** A photovoltaic generation system using grid-connected parallel inverters, the photovoltaic generation system comprising:

a photovoltaic module configured to convert photovoltaic energy into DC electrical energy;
an inverter configured to convert the DC electrical energy outputted from the photovoltaic module into AC electrical energy;
an LC filter configured to remove noise included in the AC electrical energy which is outputted from the inverter;
a Y-connected capacitor group which is connected between one terminal of a reactor in the LC filter and one terminal of the photovoltaic module and is configured to reduce stray current; and
an isolation transformer configured to block the output of a DC portion outputted from the LC filter.

**10.** The photovoltaic generation system according to claim 9, wherein stray current flowing between the photovoltaic module and a ground is determined depending on a capacitance value of the Y-connected capacitor group and a switching frequency of the inverter.

**11.** The photovoltaic generation system according to claim 9 or 10, wherein the isolation transformer is any one of a double wiring transformer and a multi-wiring transformer.

【Fig. 1】

Figure 2

【Fig. 3】

【Fig. 4】

Time(s)

Figure 5

Figure 6

【Fig. 7】

Time(s)